# EUROPÄISCHE PATENTSCHRIFT

(11) **EP 0 619 846 B1**
(45) Veröffentlichungstag und Bekanntmachung des Hinweises auf die Patenterteilung: **25.06.1997**
(21) Anmeldenummer: 93900086.5
(22) Anmeldetag: 22.12.1992
(51) Int. Cl.: C25D 5/18

(54) **VERFAHREN ZUR VERBESSERUNG DER BESCHICHTUNG VON ELEKTROLYTISCH BEHANDELTEN WERKSTÜCKEN, SOWIE ANORDNUNG ZUR DURCHFÜHRUNG DES VERFAHRENS**
METHOD OF IMPROVING THE COATING OF ELECTROLYTICALLY TREATED WORKPIECES, AND EQUIPMENT FOR CARRYING OUT THE METHOD
PROCEDE POUR L'AMELIORATION DU REVETEMENT DE PIECES TRAITEES PAR ELECTROLYSE ET DISPOSITIF POUR LA MISE EN OEUVRE DE CE PROCEDE

(30) Priorität: 31.12.1991 DE 4143247; 25.02.1992 DE 4205660
(43) Veröffentlichungstag der Anmeldung: 19.10.1994
(73) Patentinhaber: ATOTECH Deutschland GmbH, 10553 Berlin (DE)
(72) Erfinder: HÜBEL, Egon, D-8501 Feucht (DE)
(74) Vertreter: Effert, Udo, Dipl.-Ing.
(86) Internationale Anmeldenummer: DE9201086
(87) Internationale Veröffentlichungsnummer: WO9313248

(56) Entgegenhaltungen:
- PATENT ABSTRACTS OF JAPAN vol. 12, no. 365 (C-532)29. September 1988

## Beschreibung

Die Erfindung betrifft zunächst ein Verfahren zur Vermeidung von Schichtdickenunterschieden bei der elektrolytischen Beschichtung von Werkstücken, die in Abständen nebeneinander an Kathodenschienen oder kathodischen Gestellen in einem Bad angeordnet sind, wobei die Stromführung in der Schiene oder dem Gestell parallel zur Richtung der Werkstücke verläuft In der Praxis sind die kathodischen Schienen meist Warenträger, an welche die Werkstücke, insbesondere ist dabei an plattenförmige Werkstücke wie Leiterplatten gedacht, angeklammert werden. Hierbei verläuft die Reihe der Werkstücke entsprechend der Anordnung des Warenträgers waagerecht. Auch kann eine Anklammerung solcher Werkstücke an Tragstäben von Gestellen erfolgen, die sich senkrecht in das Bad hinein erstrecken. Der elektrolytische Behandlungsstrom, insbesondere ist dabei an Galvanisiervorgänge, d.h. an einen Galvanisierstrom gedacht, wird den zu behandelnden Werkstücken über den Warenträger oder über die Tragstäbe des Gestells zugeführt. Ferner sind im Bad an Trägern oder Schienen Anoden angebracht, welche den Anodenstrom führen. Das Metall der Anoden wird durch den elektrolytischen Vorgang in bekannter Weise auf der Ware abgeschieden. Der kathodische Strom erzeugt an der Kathodenschiene oder dem entsprechenden Gestelltragstab in seiner Flußrichtung einen Spannungsabfall. Die Größe des Spannungsabfalles hängt sowohl von der Größe des Stromes, als auch vom spezifischen Ohm'schen Widerstand pro Längeneinheit der Kathodenschiene oder des Gestelltragstabes ab. Damit ergibt sich ein entsprechender Spannungsabfall zwischen dem Befestigungspunkt eines Werkstückes an der Kathodenschiene oder dem Gestelltragstab bis zum Befestigungspunkt des in der Reihe nächsten Werkstückes. Von den sich gegenüberliegenden und durch den Abstand getrennten Kantenbereichen zweier benachbarter Werkstücke wirken die einen wie eine örtliche Anode und die anderen wie eine örtliche Kathode mit einer Zellenspannung, d.h. wie eine partielle elektrolytische Zelle. Dies hat zur Folge, daß der Kantenbereich der Kathodenfunktion mehr an Metallauftrag erhält, als der anodische Kantenbereich. Bei Messungen wurden 20 % und mehr Unterschied zwischen den jeweiligen Metallaufträgen festgestellt. Um diesen Nachteil zu beheben, könnte man versuchen, die Spannungsabfälle entlang der Kathodenschiene oder entsprechender Gestelltragstäbe zu verringern. Hierzu hat man beispielsweise eine Verringerung der Galvanisierstromdichte, d.h. der Ströme in den Schienen, und/oder Erhöhung der Leitfähigkeit des Materials der Schienen oder der Gestelltragstäbe und/oder eine Vergrößerung der Querschnitte der Kathodenschienen oder der Gestelltragstäbe versucht. Jede dieser Varianten ist mit Nachteilen behaftet. So erfordert die verringerte Stromdichte längere Galvanisierzeiten, d.h. die Anlage wird unwirtschaftlich. Zur Erhöhung der Leitfähigkeit bietet sich zwar Kupfer als Material an. Doch neigt Kupfer im Umfeld von galvanotechnischen bzw. elektrolytischen Bädern zu starker Korrosion, was sowchl bei den Anodenkontaktierungen, als auch den Werkstückkontaktierungen zu zusätzilchen, unkontrollierten und hohen Spannungsabfällen führt. Die vorgenannte Korrosion ist bei Edelstahl nicht vorhanden, so daß zwecks Vermeidung von Korrosionen dieser Werkstoff bevorzugt eingesetzt wird. Man muß aber den Nachteil eines etwa 40 mal höheren spezifischen Widerstandes gegenüber Kupfer in Kauf nehmen. Vergrößerungen der Querschnitte sind generell und insbesondere bei Edelstahl wegen des hohen spezifischen Gewichtes nicht in beliebigem Maße möglich. Auch entstehen dadurch relativ hohe Materialkosten. Statt dessen hat man auch eine beidseitige Kontaktierung der Anoden- oder Kathodenschienen vorgesehen. Dies reduziert zwar die Spannungsabfälle an den Schienen auf die Hälfte, bringt aber gleichzeitig neue Unsicherheiten in das Gesamtsystem. Die Anoden- und Kathodenschienen sind aushebbar, d.h. der Strom gelangt auf diese Schienen über Kontakte. In der Praxis verschmutzen und korrodieren diese Kontakte bis zum Totalausfall einer Seite. Dies wird vom System nicht erkannt, weil der verbleibende zweite Kontakt den gesamten Strom übernimmt. Die Folge sind wiederum unzulässig hohe Spannungsabfälle an der Schiene. Eine Überwachung der Kontakte verbietet sich aus Kostengründen. Außerdem sind Anordnungen bekannt, bei denen die Anodenschienen an einer Badseite und die Kathodenschiene auf der gegenüberliegenden Badseite (gegenläufige Einspeisung) kontaktiert werden. Hierbei gibt es zwar das vorstehend erörterte Kontaktproblem nicht. Die Spannungsabfälle kompensieren sich hier in begrenztem Umfang in Bezug auf die für das Galvanisieren wirksame Zellenspannung. Die Höhe der Spannungsabfälle auf den Schienen selbst bleibt davon jedoch völlig unbeeinflußt.

Die Aufgaben- bzw. Problemstellung der Erfindung besteht demgegenüber darin, die erläuterten großen Schichtdickenunterschiede im Randbereich von benachbarten Werkstücken, wie z.B. Leiterplatten, zu vermeiden, ohne nachteilige Aufwendungen zur Verringerung des Spannungsabfalles in der Kathodenschiene oder einem entsprechenden Gestelltragstab vornehmen zu müssen.

Zur Lösung dieser Aufgaben- bzw. Problemstellung ist zunächst vorgesehen, daß die Richtung der Stromeinspeisung zumindest in die kathodische Schiene oder den kathodischen Gestelltragstab während eines Behandlungsvorganges wiederholt gewechselt wird. Beispielsweise kann bei einer Gesamtbehandlungszeit von 60 Minuten der Kathodenstrom 5 Minuten von der einen Seite, dann 5 Minuten von der anderen Seite, danach wieder 5 Minuten von der erstgenannten Seite u.s.w. eingespeist werden. Diese abwechselnde Einspeisung des Kathoden stromes von beiden Seiten her bewirkt, daß sich die Polarität der Spannungsabfälle und damit der Spannung an den sich gegenüberliegenden Kanten der Werkstücke umkehrt. Infolgedessen erhalten die sich an einem solchen Abstand gegenüberliegenden Kantenbereiche zweier Werkstücke abwechselnd einen höheren und einen niedrigeren Metallauftrag. Dies gleicht sich in etwa aus, so daß insgesamt nach einem Behandlungsvorgang jede dieser beiden Kantenbereiche etwa die gleiche Metallauftragstärke besitzt.
Für die Praxis ergibt sich mit der Erfindung der besondere Vorteil, daß man die Kathodenschiene und die kathodisch betriebenen Gestelltragstäbe aus einem korrosionsunempfindlichen Edelstahl herstellen kann, ohne Gefahr zu laufen, daß der daran entstehende größere Spannungsabfall zu untolerierbar ungleichmäßigen Metallaufträgen an den sich gegenüberliegenden, erläuterten Kantenbereichen der Werkstücke führt.

Die Merkmale des Anspruches 2 ergeben Vorteile bei der absoluten Schichtdickenverteilung über die Länge des Warenträgers oder der Gestelltragstäbe.

Die Merkmale des Anspruches 3 tragen zur Vergleichmäßigung der Spannungsabfälle an einer Kathodenschiene oder eines kathodisch betriebenen Gestelltragstabes einerseits und Anodenschienen andererseits bei.

Die Merkmale des Anspruches 4 verhindern Unterbrechungen im Stromfluß während der Änderung der Stromrichtung, die u.U. zu schädlichen Auswirkungen auf den Metallauftrag führen können.

Die Ansprüche 5 und 6 beinhalten zwei alternative Verfahrensmaßnahmen, um die Änderung der Stromeinspeiserichtung entweder mit Umschaltmaßnahmen oder -mitteln und einem einzelligen Bad (Anspruch 5) oder ohne gesonderte Umschaltmaßnahmen oder -mittel, jedoch der Verwendung eines mehrzelligen Bades (Anspruch 6) zu erreichen.

Der Erfindung liegt ferner die Aufgaben- bzw. Problemstellung zugrunde, Anordnungen zur Durchführung des Verfahrens nach einem oder mehreren der Ansprüche 1 bis 6 zu schaffen. Hierzu sieht zunächst Anspruch 7 eine Anordnung zur Durchführung des Verfahrens nach einem oder mehreren der Ansprüche 1 bis 5 vor.

Die Ansprüche 8 bis 16 beinhalten mehrere vorteilhafte Ausführungsformen der Anordnung nach Anspruch 7.

Anspruch 17 betrifft eine Anordnung zur Durchführung des Verfahrens nach einem oder mehreren der Ansprüche 1 bis 5. Dies kann durch die Merkmale des Anspruches 18 ergänzt werden.

Auf den Inhalt der vorstehend nur ziffernmäßig angegebenen Ansprüche wird zur Offenbarung der Erfindung verwiesen. Weitere Vorteile und Merkmale der Erfindung sind der nachfolgenden Beschreibung und der zugehörigen Zeichnung von erfindungsgemäßen Ausführungsmöglichkeiten zu entnehmen. In den im wesentlichen schematischen Zeichnungen zeigt:
- Fig. 1 :: ein erstes Ausführungsbeispiel des Prinzipes der Erfindung in der Seitenansicht,
- Fig. 1a:: ein Diagramm der mit der Ausführung nach Fig. 1 aufgetragenen Schichtstärke über die Länge der Behandlungsstrecke,
- Fig. 2 bis 2c:: ein weiteres Ausführungsbeispiel des Prinzipes der Erfindung in der Seitenansicht,
- Fig. 2d:: ein zum Beispiel lt. Fig. 2-2c gehörendes Diagramm der aufgetragenen Schichtstärke über die Behandlungsstrecke,
- Fig. 3 :: ein Schaltbild einer Ausführungsform der Gleichstromerzeugung der Erfindung mit schematisch dargestellten Schienen,
- Fig. 4 :: die Prinzipdarstellung einer hier zur Stromeinspeisung verwendeten Schaltung,
- Fig. 5 und 5a:: die Schaltung und zugehörigen Schienen einer praktischen Ausführung des Schaltprinzipes nach Fig. 4,
- Fig. 6 und 6a:: eine weitere Ausführungsform der Erfindung mit Schaltbild und Schienen,
- Fig. 7 und 7a:: eine weitere Ausführungsform der Erfindung,
- Fig. 8 :: eine Ausführungsform der Erfindung mit Gestelltragstäben,
- Fig. 9: : eine weitere Ausführung der Erfindung, bei der die Ware in verschienene Badstationen eingesetzt wird.

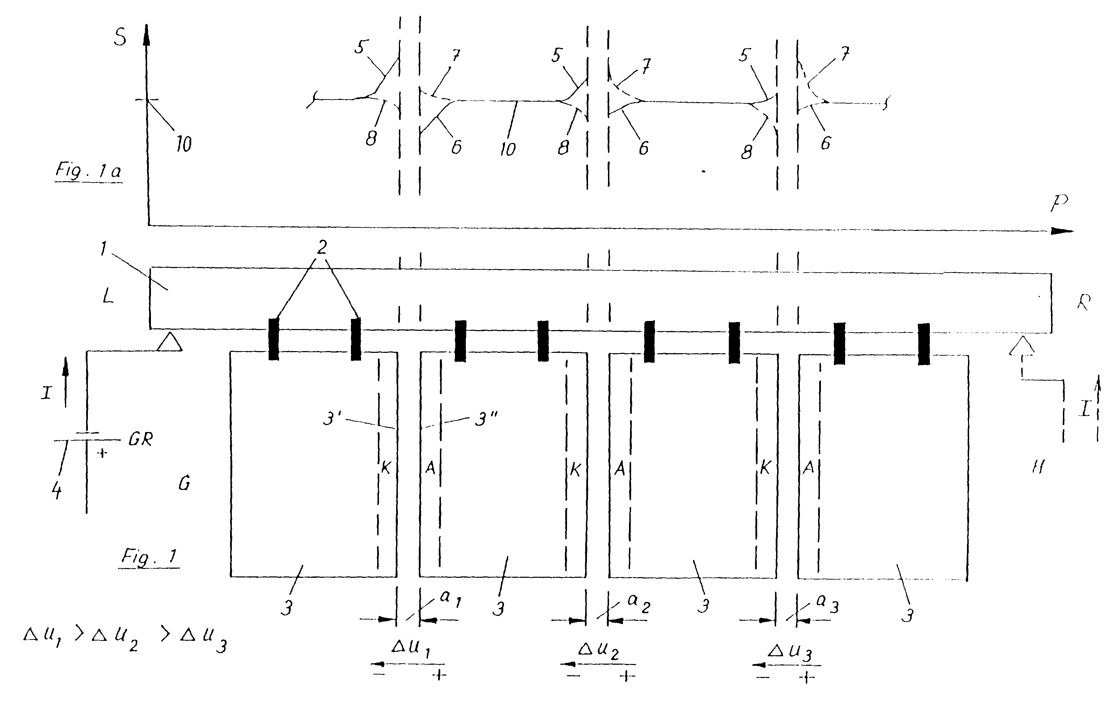

Fig. 1 zeigt an einer Kathodenschiene 1 lösbar befestigte Werkstücke, hier in Form von Platten 3 mit Klammern 2, wobei insbesondere an Leiterplatten gedacht ist. Von der Gleichstromquelle 4 wird der Kathodenstrom entweder am in der Zeichnung links dargestellten Ende L oder aber, wie gestrichelt angedeutet, an dem in der Zeichnung rechts dargestellten Ende R der Kathodenschiene 1 eingespeist. Im Falle der mit durchgezogenen Linien dargestellten Einspeisung L fließt der Kathodenstrom durch die Schiene 1 von L in Richtung R. Hierdurch entsteht an der Schiene ein Spannungsabfall, wobei zwischen einander benachbarten Werkstücken sich die Spannungsabfälle Δ U 1> Δ U 2> Δ U 3 bilden, die an den sich gegenüberliegenden Kanten 3', 3" der Werkstücke 3 anstehen. Die vorgenannten Kanten 3', 3" haben voneinander die Abstände a1, a2, a3. In der Praxis sind die Abstände a 1 u.s.w. relativ klein zu halten, da andernfalls sich an den mit "K" und "A" benannten Bereichen der sich in Abstand gegenüberliegenden Kanten 3', 3" durch Metallabscheidung Verdickungen, d.h. der sogenannte "Hundeknocheneffekt" ergibt. Fließt nun der Kathodenstrom von L in Richtung nach R, so stenen lokal mit ihrer Polarität wie angegeben die Spannungsabfälle Δ U an. Hierdurch steht beim Kantenbereich "K" eine negative Spannung in Bezug auf den gegenüberliegenden Kantenbereich "A" an, womit die von der Anode her kommenden Ionen sich in den Bereichen "K" stärker niederschlagen, d.h. dort gemäß Fig. 1a einen verstärkten Metallauftrag 5 bilden, dagegen an den entsprechenden Bereichen "A" einen verringerten Metallauftrag 6 zur Folge haben. In Fig. 1 gibt die Ordinate die relative Schichtstärke S und die Abszisse P die jeweilige Position entlang der Schiene 1 an. Dabei nimmt die Größe des zusätzlichen Metallauftrages in Richtung von L nach R ab, da in dieser Richtung auch die vorgenannten Spannungsabfälle Δ U 1 u.s.w. sich verringern, da in der Stromflußrichtung Teilströme über die Werkstücke 3 abfließen. Wird nun der Kathodenstrom bei R eingespeist (gestrichelte Darstellung), d.h. ändert er seine Flußrichtung in der Schiene 1, sa ist dann Δ U 3> Δ U 2> Δ U 1 bei gleichzeitiger Umkehr der Polarität dieser Spannungsabfälle mit der Konsequenz, daß sich die gestrichelten Erhöhungen 7 des Metallauftrages an den Kantenbereichen "A" und die verringerten, ebenfalls gestrichelt dargestellten Abscheidungen 8 im Kantenbereich "K" ergeben. In diesem Fall nimmt die Größe der Erhöhungen 7 und der Verringerungen 8 von R nach L ab. Mit anderen Worten: Die abwechselnde Speisung des Kathodenstromes von den Enden L und R der Kathodenschiene bewirkt eine Änderung der Wirkungsrichtung der Spannungsabfälle Δ U und damit eine Umkehrung der Bereiche des erhöhten oder reduzierten Metallauftrages. Diese Änderung der Stromrichtung in der Schiene 1 kann wiederholt vorgenommen werden, zumindest muß nach dem Prinzip der Erfindung einmal der Kathodenstrom von L in Richtung R und danach über etwa die gleiche Zeit von R in Richtung L fließen. Die erhöhten oder verringerten Aufträge 5 bis 8 gleichen sich in etwa aus, d.h, an den Kantenbereichen "K" und "A" entstehen etwa einander gleich starke Metallaufträge, die auch in etwa der Dicke der Metallaufträge im übrigen Bereich der Werkstücke 3 entsprechen. Die mittlere Schichtstärke ist mit 10 angegeben.

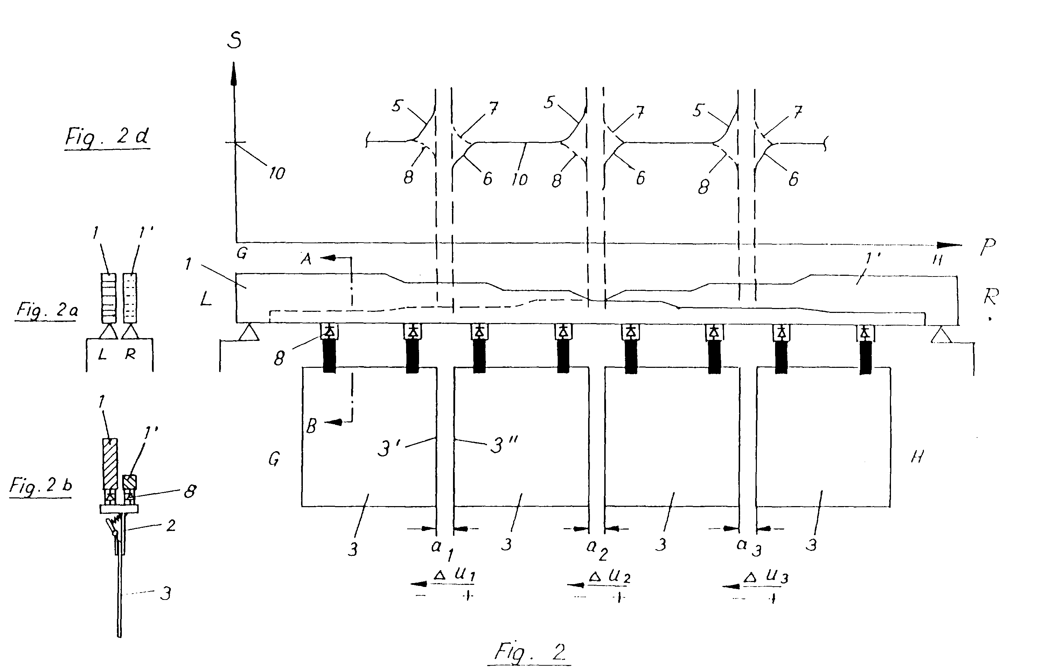

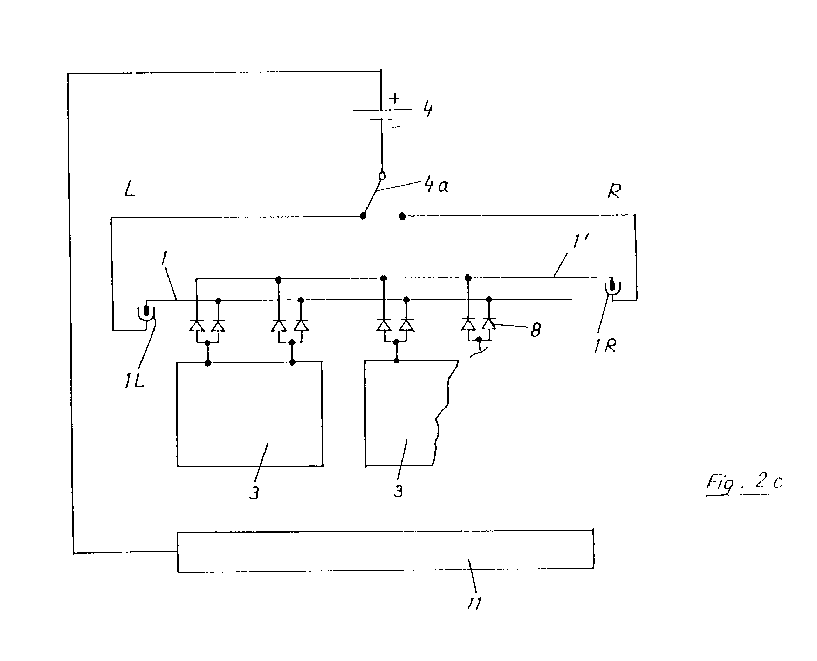

Fig. 2 zeigt eine Variante der Erfindung, bei der zwei Kathodenschienen 1, 1' vorgesehen sind, deren Querdchnitt in der Stromflußrichtung L Richtung R in der Kathodenschiene 1 und R Richtung L in der Kathodenschiene 1' sich verringern. Hierzu wird im einzelnen auf den Gegenstand der nachveröffentlichter. Patentanmeldung DE-P 40 41 589.8 der gleichen Anmelderin verwiesen und auf deren Offenbarungsinhalt Bezug genommen. Dabei beinhalten Fig. 2a eine Ansicht auf die Schienenenden von dem Ende R her, Fig. 2b einen Schnitt gemäß der Linie A-B in Fig. 2, Fig. 2c die Anordnung nach Fig. 2 schematisiert und dabei vor allem die elektrischen Verbindungen zeigend und Fig. 2d das Diagramm der über die Länge der Behandlungsstrecke aufgetragenen Stärke der Metallschicht. Zwischen den Werkstücken 3 und den Kathodenschienen 1, 1' sind Entkopplungsdioden 8 vorgesehen (siehe Insbesondere Fig. 2c), die verhindern, daß Ströme von der einen zur anderen Kathodenschiene 1, bzw. 1' fließen. Die Differenzspannungen Δ U1, Δ U 2 und Δ U 3 sind etwa einander gleich. Fig. 2c zeigt die Gleichstromquelle 4 und eine Umschaltung 4a, sowie im Bereich der Enden L, R die Schienenkontakte 1L und 1R. Es ist aber nur der Umschalter 4a für die Kathodenschienen 1, 1' dargestellt. Die Anoden sind rein schematisch mit Ziffern 11 angedeutet. Fig. 2d zeigt wieder die Metallaufträge 5 bis 8 analog Fig. 1a. Auf die entsprechenden Ausführungen zu Fig. 1a wird verwiesen. Dabei besteht aber zwischen der Größe der Aufträge 5 bis 8 beim Beispiel der Fig. 1, 1a einerseits und den der Fig. 2, 2a andererseits der Unterschied, daß im letztgenannten Beispiel sich die absoluten Beträge der Metallaufträge 5 bis 8 in Richtung von G nach H bzw. umgekehrt nicht ändern. Dies ergibt sich aufgrund der abgestuften Querschnitte der Schienen 1, 1', wodurch sich über deren gesamte Länge ein gleichmäßiger Spannungsfall pro Längeneinheit einstellt. Damit ist das absolute Maß der an den sich gegenüberstehenden Kanten 3', 3" der Werkstücke anstehenden Spannungsabfälle Δ U ohne Einfluß auf den Effekt der Erfindung, da sich dies durch die Abwechslung der Stromflußrichtung ausgleicht.

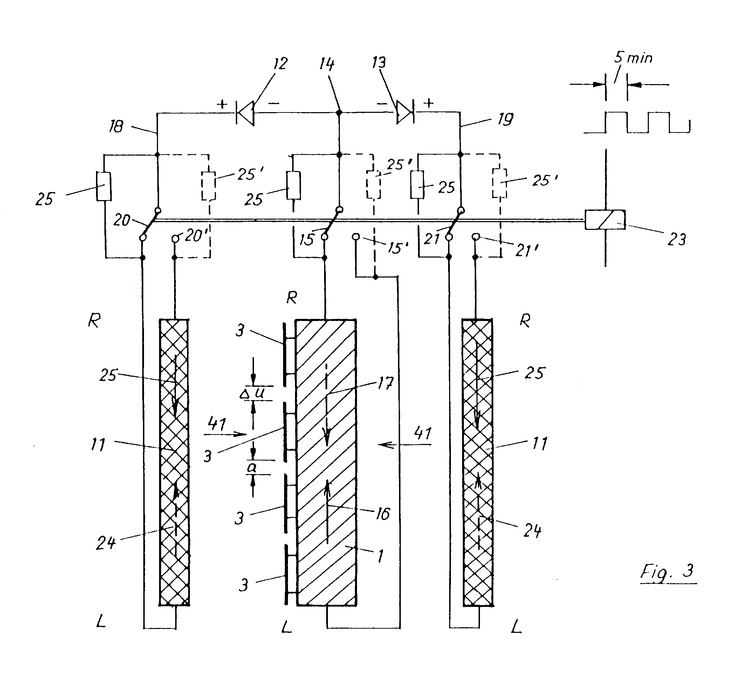

Das Ausführungsbeispiel der Fig. 3 zeigt eine Kathodenschiene 1 mit den unterhalb der Schiene hängenden Werkstücken 3. Die Kathodenschiene 1 bzw. im Ausführungsbeispiel der Fig. 2 die Kathodenschienen 1, 1' können gemäß diesen Beispielen der Erfindung die Funktion von Warenträgern haben. Die zu Fig. 1, 2 erläuterte Differenzspannung Δ U ist eingezeichnet, einschließlich einem der Abstände a. Ferner sind zwei die Anoden tragenden Anodenschienen 11 dargestellt. Die Gleichstromquelle besteht hier aus zwei Gleichrichtern 12, 13, die mit ihrer Minusseite an der Stelle 14 zusammengeführt und über einen Umschalter 15 alternativ an das eine Ende R oder das andere Ende L der Kathodenschiene legbar sind. Somit kann auch hier der Kathodenstrom gemäß mit durchgezogen dargestelltem Pfeil 16 von L in Richtung R oder gemäß mit gestrichelter Linie dargestelltem Pfeil 17 in der umgekehrten Richtung von R in Richtung L fließen. Die positiven Pole oder Anschlüsse der Gleichrichter 12, 13 sind über Leitungen 18, 19 zu Umschaltern 20, 21 geführt, um wahlweise die Enden L oder die Enden R der Anodenschienen 11 an die positive und damit den Anodenstrom liefernde Seite der Gleichrichter zu schalten. Die Umschalter 15, 20 und 21 sind miteinander gekoppelt, z.B. mittels Gleichstromschütz 23. In der dargestellten Schaltlage der Umschalter 15, 20, 21 fließen der gestrichelt dargestellte Kathodenstrom 17 sowie die ebenfalls gestrichelt dargestellten Anodenströme 24. Wird über den Gleichstromschütz die andere Schaltlage der Umschalter 15, 20, 21 bewirkt, so fließt in der Kathodenschiene 1 der Strom gemäß der mit durchgezogenem Pfeil 18 dargestellten Richtung und in den Anodenschienen 11 der Anodenstrom in Richtung der ebenfalls durchgezogen dargestellten Pfeile 25. Die Richtung der Stromverläufe in den Anodenschienen haben zwar auf die anhand der Fig. 1, 2 erläuterten Metallaufträge in den Kantenbereichen "K" und "A" keinen Einfluß. Diese Richtung der Stromverläufe in den Anodenschienen und der Kathodenschiene hat aber gemäß dem eingangs erläuterten Stand der Technik und auch gemäß der angegebenen nachveröffentlichten Anmeldung DE-P 40 41 598.8 einen günstigen Einfluß auf die an den Schienen 1, 11 entstehenden Spannungsabfälle und damit auf die wirksame Galvanisierspannung.

Oberhalb des Gleichstromschützes 23 ist schematisch dessen Umschaltung in einem Takt von beispielsweise fünf Minuten dargestellt, d.h. der Gleichstromschütz hält die Umschalter 15, 20, 21 fünf Minuten in der dargestellten Lage, schaltet dann um auf die andere Lage (Kontakte 20', 15' und 21'), wobei diese Lage wieder fünf Minuten gehalten wird. Dann erfolgt Umschaltung in die erstgenannte Lage 15, 20, 21 u.s.w., bis das Ende der Behandlungszeit erreicht ist.

Um während der Umschaltungen eine völlige Stromunterbrechung zu vermeiden, sind die Widerstände 25 und 25' vorgesehen.

Statt des elektromechanischen Schalters 23 können aber auch elektronische Schalter mit wesentlich höheren Umschaltfrequenzen und schneller Badstromausregelung verwendet werden. Hierbei läßt sich auch durch einen zeitlichen Versatz der Umschaltung erreichen, daß völlige Stromunterbrechungen vermieden werden, indem z.B. zuerst die in Fig. 3 links dargestellte Anode 11 der Vorderseite, wie dargestellt, auf eine Stromeinspeisung von L nach R geschaltet, wenige Millisekunden später die Kathodenschiene von R nach L und nach weiteren Millisekunden die Anodenschiene der Rückseite von L nach R geschaltet wird. Dabei ist die Reihenfolge der vorgenannten Umschaltungen in der Praxis ohne Bedeutung.

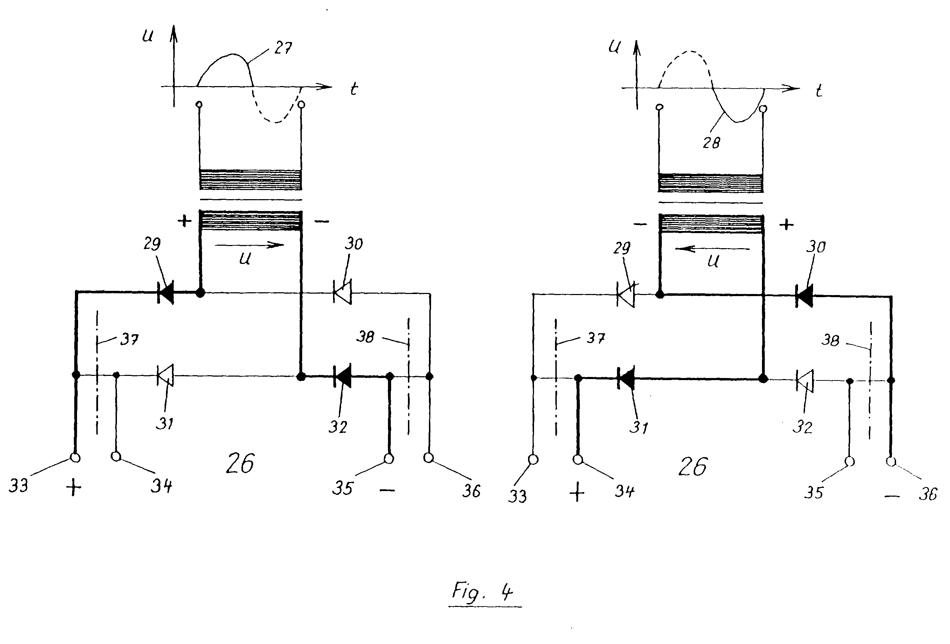

Anstelle der Verwendung von mechanischen oder elektronischen Umschaltern kann die Erfindung auch mit Anordnungen verwirklicht werden, die entweder mit unterschiedlichen Gleichrichterbrückenschaltungen (Fig. 4 bis Fig. 7) oder mit Hilfe einer Anordnung mehrerer Badstationen arbeiten.

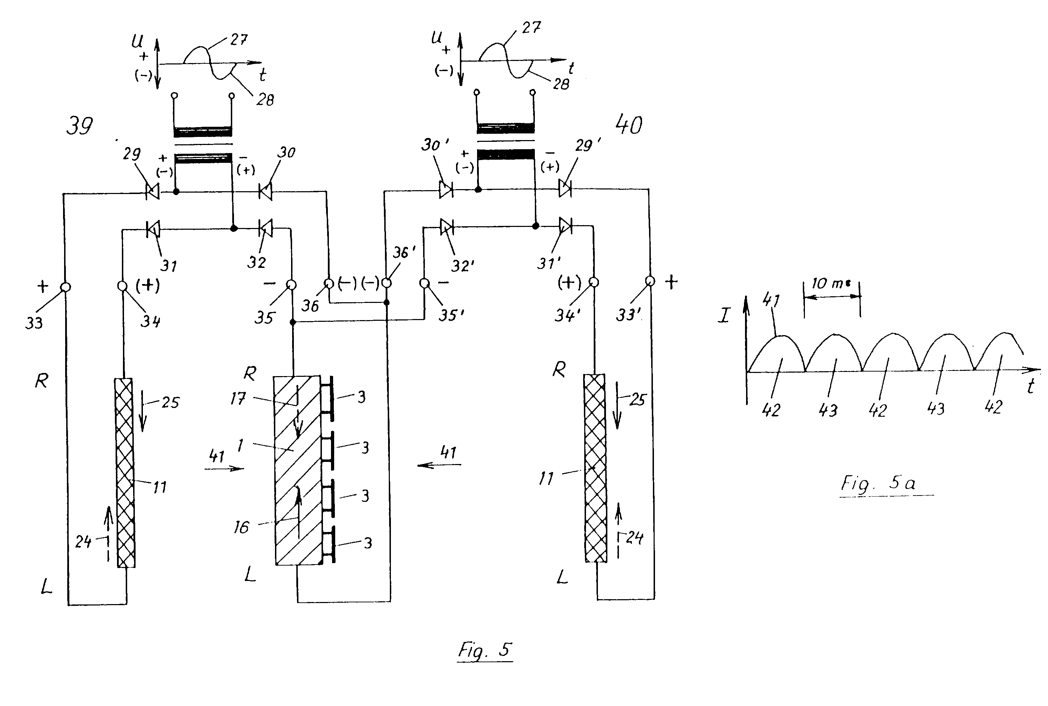

Im Beispiel der Fig. 4 und 5 zeigt Fig. 4 das elektrische Prinzip und Fig. 5 die zugehörige praktische Ausführung. Fig. 4 beinhaltet ein und denselben Brückengleichrichter 25 bei der Verarbeitung einer positiven Halbwelle 27 (linke Darstellung) und einer negativen Halbwelle 28 (rechte Darstellung) der Netzspannung U. Es sind Dioden 29 bis 32 und abgehende Gleichstromausgänge in Form von Anschlüssen 33 bis 36 vorgesehen. Im Fall der positiven Halbwelle 27 fließt der Strom über die Dioden 29, 32, d.h. die Anschlüsse 33 mit 34 sind positiv und die Anschlüsse 35 mit 36 sind negativ. Im Fall der negativen Halbwelle 28' (rechte Darstellung) fließt der Strom über die Dioden 31, 30, so daß die Anschlüsse 34 mit 33 positiv und die Anschlüsse 36 mit 35 negativ sind. Dabei sind die stromführenden Pfade dick und die nicht stromführenden Pfade dünn gezeichnet. Es handelt sich bei der vorstehenden Betrachtung der Fig. 4 also nicht um zwei separate Gleichrichter, sondern um denselben Brückengleichrichter (auch Graetz-Schaltung genannt), jedoch in verschiedenen Arbeitsstadien. Trennt man nun diesen Brückengleichrichter an den Trennstellen 37, 38 auf, so entstehen vier voneinander getrennte Ausgänge (33, 34, 35, 36). Bei positiver Netzhalbwelle 27 in Fig. 4 führen die Ausgänge 33 den Pluspol und 35 den Minuspol, während die Ausgänge 34 und 36 stromlos sind. Bei der negativen Netzhalbwelle 28 führen die Ausgänge 34 den Pluspol und 36 den Minuspol während die Ausgänge 33 und 35 stromios sind. Schließt man zwei derartig aufgetrennte Gleichrichter 39 und 40 an die Anodenschienen und an die Kathodenschiene eines elektrolytischen Bades an, so entsteht die Anordnung nach Fig. 5 in der praktischen Ausführung mit zwei separaten Gleichrichtern 39, 40. Es sind die beiden positiven Ausgänge 33, 34 und die beiden negativen Ausgänge 35, 36 vorgesehen. Die dort dargestellten Dioden und Anschlüsse tragen die gleiche Bezifferung wie in Fig. 4, wobei aber die Dioden und Anschlüsse des zweiten Gleichrichters 40 einen Beistrich erhalten haben. Ferner sind links die vorderseitige Anodenschiene 11, mittig die Kathodenschiene 1 mit Ware 3 und rechts davon die rückseitige Anodenschiene 11 dargestellt. Werden nun die Gleichrichter entsprechend Fig .5 an die Anodenschienen und die Kathodenschiene angeschlossen, so werden diese Schienen abwechselnd je Halbwelle von der einen Seite und von der anderen Seite mit Badstrom gleichet. Polarität gespeist. Die Badstromversorgung nach Fig. 5, die gemäß vorstehenden Ausführungen mit je einem aufgetrennten Einphasen-Brückengleichrichtergerät auf der Vorder- und Rückseite der Werkstücke arbeitet, hat anstelle der sonst bei zwei Gleichrichtern üblichen drei Anschlüsse (siehe Fig. 3) durch die Auftrennung der Brückenschaltungen insgesamt 6 Anschlüsse. Diese werden mit den Anoden- und Kathodenschienen nach Fig. 5 so verbunden, daß derselbe Effekt für die Spannung Δ U eintritt, wie anhand von Fig. 3 im einzelnen beschrieben. Nur ist im vorliegenden Fall der Fig. 5 die "Umschaltgeschwindigkeit" von der Netzfrequenz abhängig, d.h. sie ist wesentlich höher. Bei einer Netzfrequenz von 50 Hz wird die Einspeisungsseite (L, R) nach jeweils 10 ms gewechselt . Wie obeaber dargelegt und für das Prinzip sehr wichtig, bleibt die Polarität des Badstromes für die betreffende Schiene gleich Im einzelnen ist zu Fig. 5 noch zu sagen, daß im Falle der positiven Welle 27 der Netzspannung U ohne Klammervermerk und im Fall der negativen Welle 28 der Netzspannung U mit Klammern versehen ist. So ergibt sich aus der "-"-Bezeichnung am Anschluß 35 bei positiver Halbwelle 27 der Netzspannung ein Kathodenstromfluß von R in Richtung L (Pfeil 17) und im Fall der zweiten negativen Halbwelle 28 der Netzspannung U über den Anschluß 36 ein Kathodenstromfluß gemäß Pfeil 16. Entsprechend ergeben sich die Stromrichtungen und Anschlüsse der Anodenschienen gemäß den Pfeilen 24, 25 analog Fig. 3.

In Fig. 5 und auch in Fig. 3 ist die Richtung der Badströme mit 41 angegeben. Der Verlauf dieser Badströme ist in dem Diagramm in Fig. 5a dargestellt, wobei Ziffer 42 eine Speisung von L und Ziffer 43 eine Speisung von R her darstellt.

Bei diesen aufgetrennten Gleichrichterbrückenschaltungen besteht der große Vorteil, daß keinerlei zusätzliche Schaltgeräte erforderlich sind. Die "Umschaltung" erfolgt netzgeführt, d.h. die Steuerung oder Führung geschieht durch das Stromnetz mit seiner Frequenz und Phasenlage im Gleichrichtergerät mit den vorhandenen Dioden. Es ist durch die hier sehr schnelle Taktzeit (10 ms bei 50 Hz) der "Umschaltung" eine besonders gute Gleichmäßigkeit der Metallbeschichtung allgemein zu erwarten. Die Wanderungsgeschwindigkeit der Metallionen im Elektrolyten einerseits und die schnelle "umschaltzeit" andererseits bringen eine zusätzliche Dynamik in das elektrolytische Bad. Eine Überwachung der Kontakte der Anoden- und Kathodenschienen ist bei kritischen Anwendungen u.U. nötig, was durch einen Vergleich der Ströme in den einzelnen Pfaden technisch realisierbar ist.

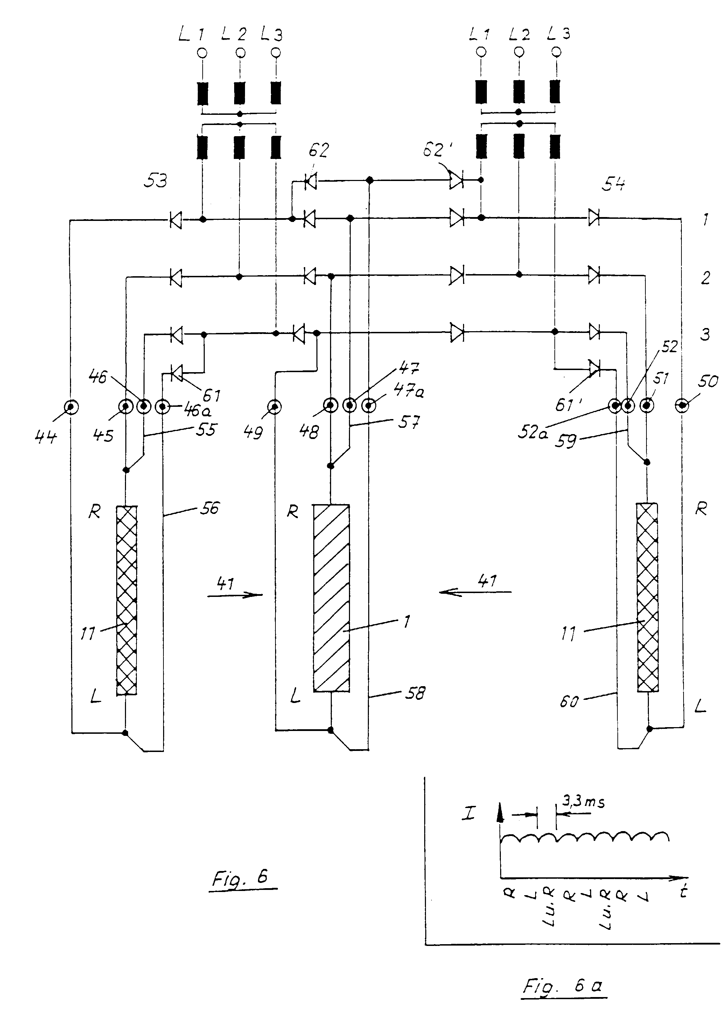

Eine in Fig. 6 dargestellte Drehstrombrückengleichrichtung empfiehlt sich bei größeren Leistungen (Badströmen) oder auch bei einem störenden Einfluß der in Fig. 5a dargestellten, relativ größen Welligkeit einer Einphasen-Badstromversorgung. Auch bei dieser Drehstromorückengleichrichtung entstehen durch Auftrennung der Strompfade entsprechende Gleichstromausgänge in Form von Anschlüssen (im vorliegenden Fall zwölf Anschlüsse 44 bis 52a). Dabei führen die Anschlüsse 45, 44 zu den Enden R, L der links dargestellten vorderen Anodenschiene 11, die Anschlüsse 48, 49 zu den Enden R, L der Kathodenschiene 1 und die Anschlüsse 51, 50 zu den Enden R, L der rechts dargestellten rückseitigen Anodenschiene 11. Die Anschlüsse 46, 47 und 52, 46a, 47a, 52a führen jeweils zu den Enden R,L der Schienen 11, 1, 11. Der Gleichrichter 53 speist die links dargestellte Anodenschiene 11 aus seinen Pluspolen 44, 45, 46 und 46a und die Kathodenschiene 1 aus seinen Minuspolen 47 und 47a, 48, 49. Der zeitliche Ablauf der Umschaltungen wird entsprechend Fig. 6a vom Drehstrom wie folgt geführt:

### Linke Anodenschiene 11 (Fig. 6)

Spannung L1-L2 Pluspol 44 an L
Spannung L2-L3 Pluspol 45 an R
Spannung L3-L1 Pluspol 46 und 46a an L und R

### Kathodenschiene 1

Spannung L1-L2 Minuspol 48 an R
Spannung L2-L3 Minuspol 49 an L
Spannung L3-L1 Minuspol 47 und 47a an L und R

Der Gleichrichter 54 speist die rechts dargestellte Anodenschiene 11 aus seinen Pluspolen 50, 51, 52 und 52a und die Kathodenschiene 1 aus seinen Minuspolen 47 und 47a, 48, 49, die identisch sind mit den Minuspolen des Gleichrichters 53. Der zeitliche Ablauf erfolgt analog wie oben angegeben. Wichtig ist, daß die beiden Gleichrichter 53, 54 so an das Netz angeschlossen werden, daß ihre vergleichbaren Gleichstromausgänge von derselben Netzphase gespeist werden. Das heißt, wenn z.B. Ausgang 44 stromführend ist, dann muß auch Ausgang 50 stromführend sein. Oder wenn von dem Gleichrichter 53 über 48 gespeist wird, muß auch zeitgleich der Gleichrichter 54 über 48 speisen. Dies bewirkt synchrones Umschalten der Einspeisungen in den Schienen.

Der dritte Gleichstromausgang ist also mit den Leitungen 55, 56 an die Enden R, L der vorderen Anodenschiene 11, mit den Leitungen 57, 58 an die Enden R, L der Kathodenschiene 1 und mit den Leitungen 59, 60 an die Enden R, L der rückwärtigen Anodenschiene 11 angeschlossen. So gilt für die links dargestellte vordere Anodenschiene 11 und die Kathodenschiene 1, daß die
Spannung L1-L2 mit + bei L von 11 und mit - bei R von 1 speist,
Spannung L2-L3 mit + bei R von 11 und mit - bei L von 1 speist,
Spannung L3-L1 mit + bei R und L von 11 und mit - bei R und L von 1 speist.

Es wirken also bei solchen Drehstromeinspeisungen zwei Phasen, d.h. zwei Drittel des Drehstromes voll im Sinne der Erfindung. In der Zeit, in der die dritte Phase wirkt, reduzieren sich die Spannungsabfälle in den Schienen wegen der Stromaufteilung auf die Hälfte, so daß die dritte Phase die Fehler zu 50 % reduziert. Dies hat ebenfalls eine Reduzierung der Schichtdickenfehler im Randbereich A, K der Werkstücke zur Folge. Es wird der Vorteil einer besseren, d.h. gleichmäßigeren Welligkeit des sich ergebenden Badstromes 41 erzielt (siehe Darstellung in Fig. 6a). Dabei ist jeweils unterhalb der betreffenden Welle die entsprechende Einspeisung und die Zeit von 3,3 ms des aktiven Wellenteiles eingezeichnet und zwar gültig für 50 Hz Netzfrequenz.

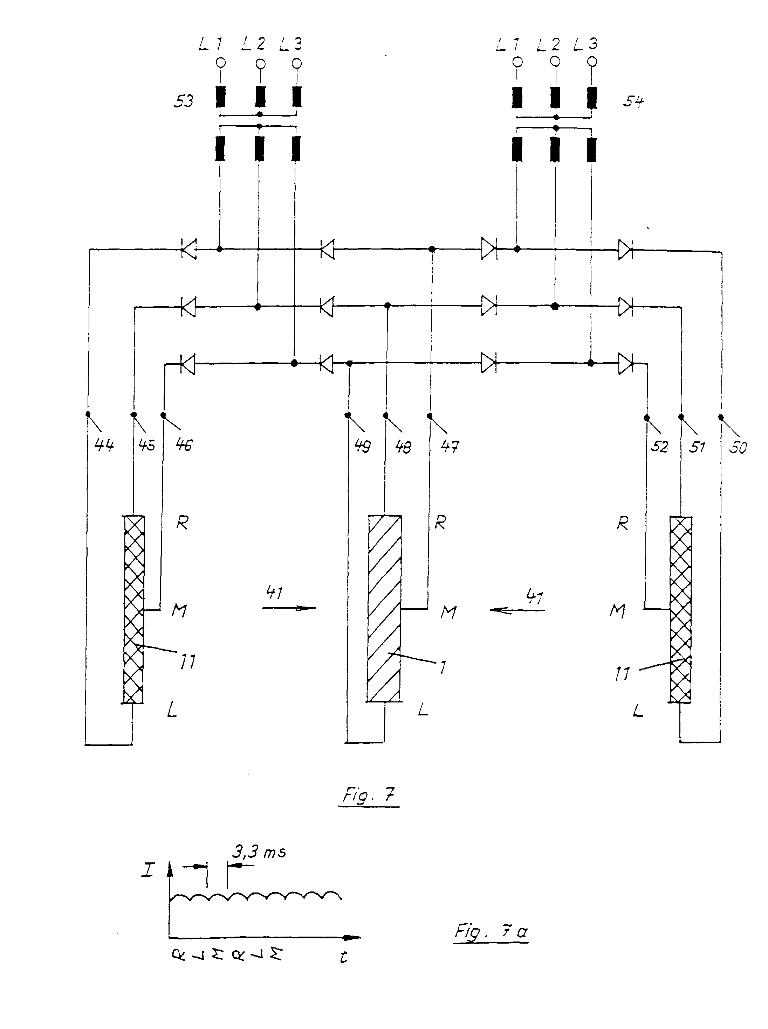

Die Ausführung nach Fig. 6 benötigt gegenüber der nachstehend erläuterten Ausführungsform der Fig. 7 lediglich zusätzlich die Dioden 61, 62, 61', 62'. Dies sind Parallel-Dioden zu den entsprechenden Gleichrichter-Dioden.

Das Ausführungsbeispiel nach Fig. 7 deckt sich hinsichtlich der Drehstrombrückengleichrichtung mit dem Beispiel der Fig. 6, so daß zunächst auf deren Erläuterung verwiesen wird. Im Unterschied zu Fig. 6 sind aber die Anschlüsse 46, 47 und 52 jeweils zu der Mitte M der Schienen 11, 1, 11 geführt. So ergibt sich beispielsweise zur links dargestellten Anodenschiene 11 eine anodenseitige Einspeisung von der Phase 1 des Gleichrichters 53 hez über den Anschluß 44 bei L, von der Phase 2 her über den Anschluß 45 bei R und von der Phase 3 her über den genannten Anschluß 46 zu M, bei gleichzeitiger Einspeisung des Gleichrichters 53 in die Kathodenschiene 1 von der Phase 1 her über den Anschluß 48 bei R, von der Phase 2 her über den Anschluß 49 bei L und von der Phase 3 her über den Anschluß 47 bei M. Die rückseitige Speisung der rechts dargestellten Anodenschiene 11 erfolgt analog (wie vorstehend erläutert).

Der Gleichrichter 53 speist also die links dargestellte Anodenschiene 11 aus seinen Pluspolen 44, 45, 46 und die Kathodenschiene 1 aus seinen Minuspolen 47, 48, 49.

Der zeitliche Ablauf der Umschaltungen wird entsprechend Fig. 7a vom Drehstrom wie folgt geführt:

### Linke Anodenschiene 11 (Fig. 6)

Spannung L1-L2 Pluspol 44 an L
Spannung L2-L3 Pluspol 45 an R
Spannung L3-L1 Pluspol 46 an M

### Kathodenschiene 1

Spannung L1-L2 Minuspol 48 an R
Spannung L2-L3 Minuspol 49 an L
Spannung L3-L1 Minuspol 47 an M

Der Gleichrichter 54 speist die rechts dargestellte Anodenschiene 11 aus seinen Pluspolen 50, 51, 52 und die Kathodenschiene 1 aus seinen Minuspolen 47, 48, 49, die identisch sind mit den Minuspolen des Gleichrichters 53. Der zeitliche Ablauf erfolgt analog wie oben angegeben. Wichtig ist, daß die beiden Gleichrichter 53,.54 so an das Netz angeschlossen werden, daß ihre vergleichbaren Ausgänge von der selben Netzphase gespeist werden. Das heißt, wenn z.B. Ausgang 44 stromführend ist, dann muß auch Ausgang 50 stromführend sein. Oder wenn von Gleichrichter 53 über 48 gespeist wird, muß auch Gleichrichter 54 über 48 speisen. Dies bewirkt synchrones Umschalten der Einspeisungen in die Schienen. Fig. 7a entspricht in der Welligkeit des Stromes über die Zeit der Fig. 6a. Nur ist anstelle der Phasenangabe "L und R" in Fig. 6a bei Fig. 7a angegeben "M".

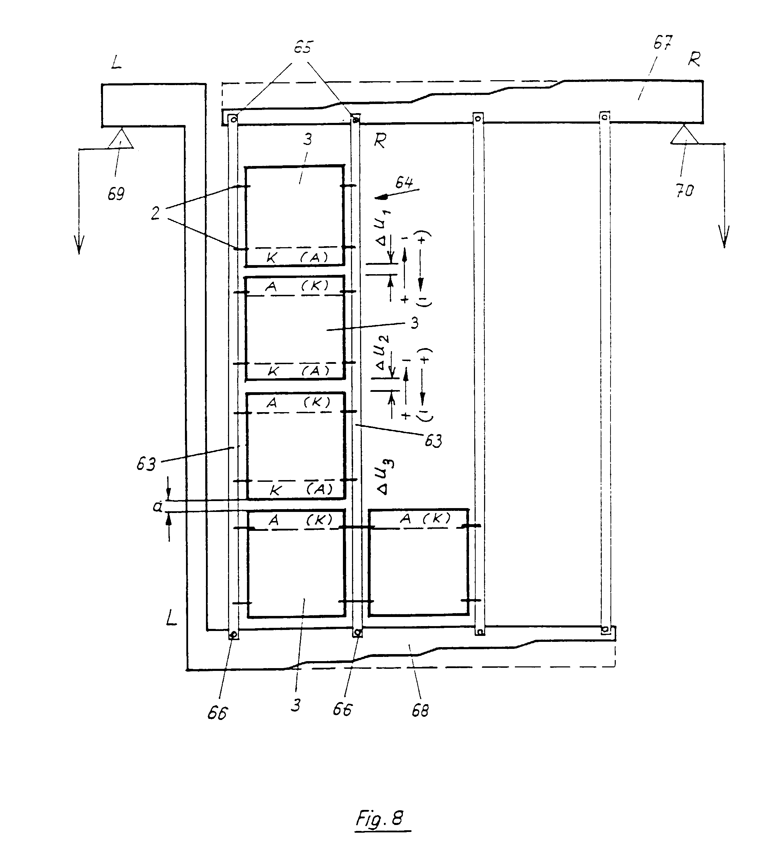

Fig. 8 zeigt, daß Problemstellung und -lösung der Erfindung auch, wie eingangs bereits erwähnt, bei einer Anordnung zum Einsatz kommen können, bei der die Werkstücke 3 in Abständen a übereinander an Tragstäben 63 von Gestellen 64 ebenfalls lösbar angeklammert (2) sind. Die Tragstäbe 63 besitzen Enden 65 und 66, wobei die in Fig. 8 oberen Enden 65 mit einer Kathodenschiene 67 und die unteren Enden mit einer weiteren Kathodenschiene 68 verbunden sind. Entlang der Tragstäbe 63 entstehen - je nach Stromflußrichtung - von oben nach unten bzw. von unten nach oben (bezogen auf die Darstellung in Fig. 8) Spannungsabfälle, welche an den Abständen a wiederum Spannungsabfälle Δ U zwischen den Kanten der Randbereiche "A" bzw. "K" bewirken. Es wird gemäß der Erfindung abwechselnd die untere Kathodenschiene 68 bei 69 oder die obere Kathodenschiene 67 bei 70 an den Minuspol der Gleichstromquelle gelegt, d.h. sie erhalten alternierend den Kathodenstrom jeweils für einen gewissen Zeitabschnitt. Damit ergeben sich über die Anschlüsse 65, 66 abwechselnd (in Fig. 8) von unten nach oben oder von oben nach unten fließende Kathodenströme in den Tragstäben 63. Bei den Bezeichnungen in Fig. 8 sind bei einem Anschluß des Minuspoles der Gleichstromquelle bei 69 die Polaritäts-Eintragungen gültig, die einen Klammervermerk haben; dagegen bei einem Anschluß des Minuspols der Gleichstromquelle am Punkt 70 die Eintragungen, die keinen Klammervermerk besitzen. Im übrigen wird hinsichtlich der Wirkung auf die Ausführung zu Fig. 1 verwiesen. Der Einsatz der Erfindung bei derartigen Gestellen ist deswegen von besonderer Bedeutung, da diese Gestelle relativ lang sein können und sollen, und sich hierbei die Spannungsabfälle besonders bemerkbar machen. Insbesondere wegen der bei solchen Gestellen geforderten hohen mechanischen Festigkeit kann Kupfer in der Regel nicht verwendet werden, sondern es muß für die Tragstäbe dieser Gestelle Edelstahl zum Einsatz kommen. Mit der Erfindung kann man somit besonders tiefe Bäder bauen und trotzdem nachteilige Schichtdickenunterschiede an den Randbereichen "K" und "A" vermeiden. Wie in Fig. 8 angedeutet, können mehrere Traggestelle, dort drei Traggestelle, nebeneinander vorgesehen sein.

Die Kathodenschienen 67, 68 können entweder, wie gestrichelt dargestellt, über ihre Länge einen gleichmäßigen Querschnitt haben, oder aber auch einen abgestuften Querschnitt, wie es beim Beispiel der Fig. 2 - 2d dargestellt und erläutert ist.

Der Einsatz der Erfindung bei Traggestellen ermöglicht es, mit Tragstäben eines gegebenen Durchmessers eine größere Länge (Tiefe) zu realisieren, d.h. die betreffende Galvanoanlage wirtschaftlicher zu machen. An diesen längeren Tragstäben können entsprechend mehr an Werkstücken untergebracht werden, was allerdings die Stärke des in den Tragstäben fließenden Stromes erhöht. Dies wiederum hat größere Spannungsabfälle Δ U zur Folge. Diese an sich unzulässig größen Spannungsabfälle Δ U werden aber durch die erfindungsgemäß abwechselnde Speisung der Tragstäbe von beiden Seiten her in ihrer Wirkung auf die Stärke der aufgetragenen Metalischicht in den Randbereichen "K" und "A" der Werkstücke im wesentlichen kompensiert.

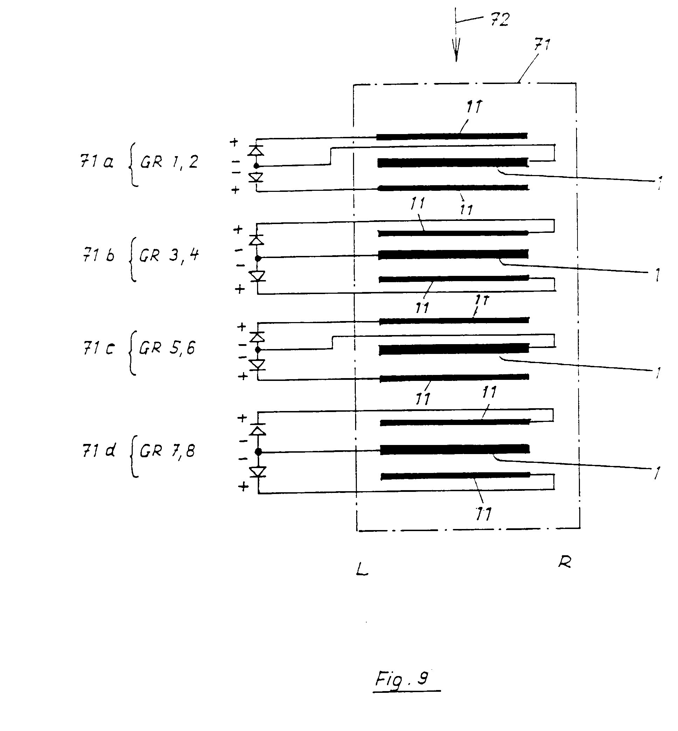

Das Ausführungsbeispiel nach Fig. 9 zeigt ein mehrzelliges, hier 4-zelliges Bad 71, dessen Anoden- und Kathodenanschlüsse zellenweise in einer unterschiedlichen Stromflußrichtung mit den Gleichrichtern GR 1, 2 - GR 7, 8 kontaktieren. Die Anodenschienen sind jeweils mit 11 und die Kathodenschiene jeweils mit 1 beziffert. die Enden tragen wiederum die Bezeichnungen L und R. Angenommen der Warenträger wird von der Anlage her in Pfeilrichtung 72 angefahren und setzt zunächst die Ware in die Badzelle 71a ab, die von Gleichrichtern GR 1, 2 gespeist wird. Es ist ersichtlich, daß hier eine Stromeinspeisung in die Anodenschienen 11 vom Pluspol her bei L und die Einspeisung vom Minuspol her an die Kathodenschiene 1 bei deren Ende R erfolgt. Sind 50% der insgesamt vorgesehenen Expositionszeit (Behandlungszeit) abgelaufen, so wird die Ware aus der Zelle 71e herausgehoben und in die nächste Zelle 71b eingeführt, die von Gleichrichtern GR 3, 4 gespeist wird. Hier sind die Einspeisungsrichtungen gegenüber der Zelle 71a genau umgekehrt. Die positiven Ausgänge des Gleichrichters sind zu den Enden R der Anodenschienen 11 geführt und sein negativer Anschluß an das Ende L der Kathodenschiene 1. In der Wirkung auf die Schichtdickenverteilung entspricht dies der erfindungsgemäßen Umschaltung der Einspeisungen von L nach R für die Anodenschienen und für die Kathodenschiene von R nach L. Dies jedoch ohne Einsatz eines Umschalters.

Gleichzeitig kompensieren sich damit sehr vorteilhaft weitere Toleranzen von Zelle 71a und 71b wie z.B. ungleichmäßige Anodenknüppel, Abblendungen und Geometrien, die Einfluß auf die Qualität der galvanotechnischen Behandlung haben. Stehen wie in Fig. 9 dargestellt weitere gleichartige Zellen 71c, 71d zur Verfügung, so kann hier z.B. die Behandlung auf alle vier Zellen mit je 25% Behandlungszeit ausgedehnt werden. Die Kompensation von Toleranzen wird dadurch weiter verbessert, desgleichen auch die erfindungsgemäße Schichtdickenkompensation.

Falls eine Ware in unterschiedlichen elektrolytischen Bädern galvanisiert wird, erfolgt der Anschluß der Gleichrichter an die Anodenschienen und an die Kathodenschiene abwechselnd von den Seiten L und R entsprechend Fig. 9.

Beispiel: Kupferbad wird wie 71a in Fig. 8 angeschlossen. Ein darauf folgendes Zinnbad wird wie 71b angeschlossen.

Auch dadurch erfolgt eine zumindest summarische Angleichung der Schichtstärken im Randbereich der Waren im Sinne der Erfindung.

## Patentansprüche

1. Verfahren zur Vermeidung von Schichtdickenunterschieden bei der elektrolytischen Beschichtung von Werkstücken, die in Abständen nebeneinander an Kathodenschienen oder an kathodischen Gestellen in einem Bad angeordnet sind, wobei die Stromführung in der Schiene oder dem Gestell parallel zur Richtung der Werkstücke verläuft, wobei der Strom vom einen und/oder anderen Ende in die Kathodenschiene (1, 67, 68), die kathodischen Gestelltragstäbe (63), die Anoden und/oder die die Anoden haltenden Anodenschienen (11) eingespeist wird und der Stromeinspeisungsort zumindest in die Kathodenschiene und oder die kathodischen Gestelltragstäbe während der elektrolytischen Behandlung eines Werkstückes zumindest einmal gewechselt wird.

2. Verfahren nach Anspruch 1, dadurch gekennzeichnet, daß gleichzeitig mit dem Wechsel des Stromeinspeisungsortes in die Kathodenschiene (1, 67, 68) oder die Gestelltragstäbe (63) auch ein Wechsel des Stromeinspeisungsortes für den Stromfluß in die Anoden oder in die Anodenschienen (11) erfolgt.

3. Verfahren nach einem der Ansprüche 1 oder 2, dadurch gekennzeichnet, daß der Stromeinspeisungsort in die Kathodenschiene (1, 67, 68) oder die Gestelltragstäbe (63) und der Stromeinspeisungsort in die Anoden oder die Anodenschienen (11) an entgegengesetzten Enden liegen, so daß die Richtung des kathodischen Stromflusses der Richtung des anodischen Stromflusses entgegengesetzt ist.

4. Verfahren nach einem der Ansprüche 1 - 3, dadurch gekennzeichnet, daß der Stromfluß in der einen Richtung erst dann abgeschaltet wird, wenn der in der Gegenrichtung fließende Strom bereits zugeschaltet ist.

5. Verfahren nach einem der Ansprüche 1 - 4, dadurch gekennzeichnet, daß der Wechsel des Stromeinspeisungsortes entweder über den Gleichstromerzeuger (26) oder innerhalb der Stromzuführung zwischen dem Gleichstromerzeuger und den in einer Zelle des Bades befindlichen Anlagenteilen einschließlich der Werkstücke (3) erfolgt.

6. Verfahren nach einem der Ansprüche 1 - 4, dadurch gekennzeichnet, daß die Werkstücke (3) in einer Zelle des Bades während einer bestimmten Expositionszeit mit einer bestimmten Stromflußrichtung in den Kathodenschienen (1, 67, 68), den Gestelltragstäben (63) und den Anoden oder Anodenschienen (11) behandelt, danach in eine weitere Zelle dieses oder eines anderen Bades gebracht und in dieser Zelle mit entgegengesetzter Stromflußrichtung an den Kathodenschienen (1, 67, 68), den Gestelltragstäben (63) und den Anoden oder Anodenschienen (11) über die gleiche Expositionszeit behandelt werden.

7. Anordnung zur Durchführung des Verfahrens nach einem der Ansprüche 1 - 6, dadurch gekennzeichnet, daß eine Kathodenschiene (1, 67, 68) oder ein Traggestell (64) mit Gestelltragstäben (63) Mittel zur Anbringung einer Reihe nebeneinander und im Abstand (a) voneinander befindlicher Werkstücke (3) aufweisen, daß die Kathodenschiene (1, 67, 68) oder das Traggestell (64) an ihren einander entgegengesetzt liegenden Enden (L, R) jeweils elektrisch mit dem Minuspol einer Stromquelle verbindbar sind, und daß elektromechanische Umschalter oder elektronische Gleichstromerzeuger-Schaltungen (26) vorgesehen sind, mit denen der Minuspol der Stromquelle wechselweise entweder an das eine Ende (L) oder an das andere Ende (R) anschließbar ist.

8. Anordnung nach Anspruch 7, dadurch gekennzeichnet, daß die Anoden oder die Anodenschienen (11) an ihren Enden (L, R) mit dem Pluspol des Gleichstromerzeugers verbindbar sind und daß elektromechanische Umschalter oder elektronische Gleichstromerzeuger-Schaltungen vorgesehen sind, um im gleichen Takt mit dem Schaltwechsel an der Kathodenschiene (1, 67, 68) oder dem Traggestell (64) entweder das eine Ende (L) oder das andere Ende (R) der Anoden oder der Anodenschienen (11) an den Pluspol des Gleichstromerzeugers anzuschließen.

9. Anordnung nach einem der Ansprüche 7 oder 8, dadurch gekennzeichnet, daß für jede zu behandelnde Reihe von Werkstükken (3) zwei Kathodenschienen (1, 1') vorgesehen sind, daß der Ohm'sche Widerstand pro Längeneinheit der Kathodenschienen (1, 1') in Stromflußrichtung (bei 1 von R nach L; bei 1' von L nach R) abnimmt, daß jede dieser Kathodenschienen (1, 1') für ihre jeweiligen Enden (L, R) gesonderte Anschlüsse an den Minuspol des Gleichstromerzeugers aufweist, und daß die Werkstücke (3) über Entkopplungsdioden (8) an die beiden Kathodenschienen (1, 1') angeschlossen sind.

10. Anordnung nach Anspruch 9, dadurch gekennzeichnet, daß der Ohm'sche Widerstand pro Längeneinheit der Anodenschienen (11) in Stromflußrichtung in den Anodenschienen zunimmt.

11. Anordnung nach einem der Ansprüche 7 - 10, dadurch gekennzeichnet, daß als Gleichstromerzeuger eine Doppelgleichrichteranordnung (12, 13) mit einem elektromechanischen Umschalter oder mit elektronischen Gleichstromerzeuger-Schaltungen mit Stromzuführung zumindest zu der Kathodenschiene (1, 67, 68) vorgesehen ist.

12. Anordnung nach Anspruch 11, gekennzeichnet durch Mittel, beispielsweise Widerstände (25, 25'), zur Aufrechterhaltung eines ständigen Stromflusses zur Kathodenschiene (1, 67, 68) während des Wechsels des Stromeinspeisungsortes.

13. Anordnung nach einem der Ansprüche 7 - 10, dadurch gekennzeichnet, daß als Gleichstromerzeuger mindestens ein aufgetrennter Einphasen-Brückengleichrichter (26; bzw. 39, 40) dient, dessen Ausgänge (33 bis 36, 33' bis 36') über die Gleichchrichterdioden (29 bis 32; 29' bis 32') mit der die Werkstücke (3) tragenden Kathodenschiene (1, 67, 68) oder den Traggestellen (64) einerseits sowie mit den Anoden oder den Anodenschienen (11) andererseits verbunden sind.

14. Anordnung nach einem der Ansprüche 7 - 10, dadurch gekennzeichnet, daß als Gleichstromerzeuger mindestens ein aufgetrennter Dreiphasen-Brückengleichrichter mit sechs Gleichstromausgängen, bevorzugt zwei aufgetrennte Dreiphasen-Brückengleichrichter (53, 54) mit neun Gleichstromausgängen vorgesehen ist oder sind, wobei ein negativer Gleichstromausgang mit dem einen Ende (R) der Kathodenschiene (1, 67, 68) verbunden ist, während ein anderer negativer Gleichstromausgang mit dem anderen Ende (L) der Kathodenschiene (1, 67, 68) verbunden ist, daß entsprechende positive Gleichstromausgänge mit den Enden (L) und (R) der vorderen und rückwärtigen Anoden oder Anodenschienen (11) verbunden sind und daß der dritte negative Gleichstromausgang der aufgetrennten Dreiphasen-Brükkengleichrichteranordnung mit der Mitte (M) der Kathodenschiene (1, 67, 68) verbunden ist und die dritten positiven Ausgänge mit den Mitten (M) der Anoden oder Anodenschienen (11) verbunden sind.

15. Anordnung nach einem der Ansprüche 7 - 10, dadurch gekennzeichnet, daß als Gleichstromerzeuger mindestens ein aufgetrennter Dreiphasen-Brückengleichrichter mit acht Gleichstromausgängen, bevorzugt zwei aufgetrennte Dreiphasen-Brückengleichrichter (53, 54) mit zwölf Gleichstromausgängen vorgesehen ist oder sind, wobei davon drei Ausgänge (46, 47, 52) durch Entkopplungsdioden (61, 61', 62, 62'), die zugleich die Funktion von Gleichrichterdioden erfüllen, Parallelausgänge (46a, 47a, 52a) haben und daß diese parallelen Gleichstromausgänge, nämlich vier (46, 46a, 47, 47a) bei einem Dreiphasen-Brückengleichrichter oder sechs (46, 46a, 47, 47a, 52, 52a) bei zwei Dreiphasen-Brückengleichrichtern an die Enden der Anoden oder Anodenschienen (11) und an die Enden der Kathodenschiene (1, 67, 68) oder eines entsprechenden Traggestelles (64) geführt sind, und zwar die positiven Ausgänge (46, 46a) von dem ersten Brückengleichrichter (53) an beide Enden (L) und (R) der einen Anode oder Anodenschiene (11), die negativen Ausgänge (47, 47a) vom ersten Brückengleichrichter (53) gemeinsam mit den entsprechenden negativen Ausgängen des zweiten Brückengleichrichters (54) an beide Enden der Kathodenschiene (1, 67, 68) oder des entsprechenden Traggestelles (64) und die positiven Ausgänge (52, 52a) des zweiten Brückengleichrichters (54) an beide Enden (L) und (R) der anderen Anode oder Anodenschiene (11).

16. Anordnung nach einem der Ansprüche 7 - 15, dadurch gekennzeichnet, daß für den Halt der Werkstücke (3) durch Gestelltragstäbe (63) von Traggestellen (64) diese Werkstücke im Abstand (a) in einer in Ausrichtung der Gestelltragstäbe (63) verlaufenden Reihe nebeneinander angeordnet sind, daß die Gestelltragstäbe (63) mit ihren an einer Seite der Anordnung befindlichen Enden (R; 65) an einer ersten Kathodenschiene (67) und die anderen Enden (L; 66) an einer zweiten Kathodenschiene (68) angeschlossen sind, und daß die beiden Kathodenschienen abwechselnd mit dem Minuspol des Gleichstromerzeugers verbindbar sind.

17. Anordnung zur Durchführung des Verfahrens nach einem der Ansprüche 1 - 5, dadurch gekennzeichnet, daß in einem mehrzelligen Bad (71) zumindest zwei Zellen (71a, 71b) in Transportrichtung (72) der Ware hintereinander angeordnet sind, daß zu jeder dieser Zellen ein Gleichrichter (GR 1, 2; GR 3, 4) gehört, daß von jedem dieser Gleichrichter Stromanschlüsse in die jeweilige Zelle führen, wobei die zellenseitigen Stromanschlüsse zu Anschlüssen zumindest einer Kathodenschiene (1) oder eines Traggestelles (64) mit Gestelltragstäben (63) führen, die Mittel zur Anbringung einer Reihe nebeneinander und im Abstand (a) voneinander befindlichen Werkstücken (3) aufweisen, wobei die vom ersten Gleichrichter (GR 1, 2) zur ersten Zelle (71a) führenden Anschlüsse an die Kathodenschiene (1) oder das Traggestell (64) und die vom zweiten Gleichrichter (GR 3, 4) zur zweiten Zelle (71b) führenden Anschlüsse an die Kathodenschiene (1) oder das Traggestell (64) an jeweils entgegengesetzt angeordneten Enden angebracht sind.

18. Anordnung nach Anspruch 17, dadurch gekennzeichnet, daß mehrere Paare (71a, b; 71c, d) solcher Zellen in Transportrichtung (72) der Ware im Bad (71) hintereinander angeordnet sind.

## Claims

1. Method of avoiding differences in the layer thickness during the electrolytic coating of workpieces, which are disposed adjacent one another with spacings therebetween on cathode bars or on cathodic frames in a bath, the power supply in the bar or in the frame running parallel to the direction of the workpieces, the current being supplied from one end and/or from the other end to the cathode bar (1, 67, 68), the cathodic frame supporting rods (63), the anodes and/or the anode bars (11) retaining the anodes, and the location where the current is supplied at least to the cathode bar and/or to the cathodic frame supporting rods is changed at least once during the elecrolytic treatment of a workpiece.

2. Method according to claim 1, characterised in that, simultaneously with the change in the location where the current is supplied to the cathode bar (1, 67, 68) or to the frame supporting rods (63), there is also a change in the location where the flow of current is supplied to the anodes or to the anode bars (11).

3. Method according to one of claims 1 or 2, characterised in that the location where the current is supplied to the cathode bar (1, 67, 68) or to the frame supporting rods (63) and the location where the current is supplied to the anodes or to the anode bars (11) are situated at opposite ends, so that the direction of the cathodic flow of current is opposite to the direction of the anodic flow of current.

4. Method according to one of claims 1 - 3, characterised in that the flow of current in one direction is only switched-off when the current flowing in the opposite direction is already switched-on.

5. Method according to one of claims 1 - 4, characterised in that the location where the current is supplied is changed either via the direct-current generator (26) or internally of the power supply between the direct-current generator and the parts of the system situated in a cell of the bath, including the workpieces (3).

6. Method according to one of claims 1 - 4, characterised in that the workpieces (3) in one cell of the bath are treated for a predetermined exposure period with a predetermined direction of current flow in the cathode bars (1, 67, 68), the frame supporting rods (63) and the anodes or anode bars (11), then brought into an additional cell of this or another bath and treated over the same exposure period in this cell with an opposed direction of current flow at the cathode bars (1, 67, 68), the frame supporting rods (63) and the anodes or anode bars (11).

7. Arrangement for accomplishing the method according to one of claims 1 - 6, characterised in that a cathode bar (1, 67, 68) or a supporting frame (64) with frame supporting rods (63) has means for the mounting of a raw of workpieces (3), which are situated adjacent one another with a spacing (a) therebetween, in that the cathode bar (1, 67, 68) or the supporting frame (64) is electrically connectable to the respective negative pole of a current source at their oppositely situated ends (L, R), and in that electromechanical changeover switches or electronic direct-current generator circuits (26) are provided, by means of which the negative pole of the current source is alternately connectable either to one end (L) or to the other end (R).

8. Arrangement according to claim 7, characterised in that the anodes or the anode bars (11) are connectable at their ends (L, R) to the positive pole of the direct-current generator, and in that electromagnetic changeover switches or electronic direct-current generator circuits are provided in order to connect either one end (L) or the other end (R) of the anodes or the anode bars (11) to the positive pole of the direct-current generator in synchronism with the change in switching at the cathode bar (1, 67, 68) or the supporting frame (64).

9. Arrangement according to one of claims 7 or 8, characterised in that two cathode bars (1, 1') are provided for each raw of workpieces (3) to be treated, in that the ohmic resistance per unit of length of the cathode bars (1, 1') decreases in the direction of current flow (from R to L in the case of 1; from L to R in the case of 1'), in that each of these cathode bars (1, 1') has, for their respective ends (L, R), separate connections with the negative pole of the direct-current generator, and in that the workpieces (3) are connected to the two cathode bars (1, 1') via uncoupling diodes (8).

10. Arrangement according to claim 9, characterised in that the ohmic resistance per unit of length of the anode bars (11) increases in the direction of current flow in the anode bars.

11. Arrangement according to one of claims 7 - 10, characterised in that a full-wave rectifier arrangement (12, 13) is provided as the direct-current generator with an electromechanical changeover switch or with electronic direct-current generator circuits with a power supply at least to the cathode bar (1, 67, 68).

12. Arrangement according to claim 11, characterised by means, for example resistors (25, 25'), for maintaining a steady flow of current to the cathode bar (1, 67, 68) during the changing of the current supply location.

13. Arrangement according to one of claims 7 - 10, characterised in that at least one interrupted single-phase bridge rectifier (26; or 39, 40) serves as the direct-current generator, the outputs (33 to 36, 33' to 36') of which rectifier are connected, via the rectifier diodes (29 to 32; 29' to 32'), to the cathode bar (1, 67, 68) carrying the workpieces (3) or to the supporting frames (64), on the one hand, and to the anodes or the anode bars (11), on the other hand.

14. Arrangement according to one of claims 7 - 10, characterised in that at least one interrupted three-phase bridge rectifier is provided as the direct-current generator with six direct-current outputs, preferably two interrupted three-phase bridge rectifiers (53, 54) are provided with nine direct-current outputs, one negative direct-current output being connected to one end (R) of the cathode bar (1, 67, 68), while another negative direct-current output is connected to the other end (L) of the cathode bar (1, 67, 68), in that corresponding positive direct-current outputs are connected to the ends (L) and (R) of the front and rear anodes or anode bars (11), and in that the third negative direct-current output of the interrupted three-phase bridge rectifier arrangement is connected to the centre (M) of the cathode bar (1, 67, 68), and the third positive outputs are connected to the centres (M) of the anodes or anode bars (11).

15. Arrangement according to one of claims 7 - 10, characterised in that at least one interrupted three-phase bridge rectifier is provided as the direct-current generator with eight direct-current outputs, preferably two interrupted three-phase bridge rectifiers (53, 54) are provided with twelve direct-current outputs, of which three outputs (46, 47, 52) have parallel outputs (46a, 47a, 52a) through uncoupling diodes (61, 61' 62, 62'), which simultaneously fulfil the function of rectifier diodes, and in that these parallel direct-current outputs, namely four (46, 46a, 47, 47a) in the case of a three-phase bridge rectifier or six (46, 46a, 47, 47a, 52, 52a) in the case of two three-phase bridge rectifiers, are guided to the ends of the anodes or anode bars (11) and to the ends of the cathode bar (1, 67, 68) or of a corresponding supporting frame (64), i.e. the positive outputs (46, 46a) from the first bridge rectifier (53) to both ends (L) and (R) of one anode or anode bar (11), the negative outputs (47, 47a) from the first bridge rectifier (53), together with the corresponding negative outputs of the second bridge rectifier (54), to both ends of the cathode bar (1, 67, 68) or of the corresponding supporting frame (64), and the positive outputs (52, 52a) of the second bridge rectifier (54) to both ends (L) and (R) of the other anode or anode bar (11).

16. Arrangement according to one of claims 7 - 15, characterised in that, for retaining the workpieces (3) by frame supporting rods (63) of supporting frames (64), these workpieces are disposed adjacent one another with a spacing (a) therebetween in a raw extending in alignment with the frame supporting rods (63), in that the ends (R; 65) of the frame supporting rods (63) situated on one side of the arrangement are connected to a first cathode bar (67), and the other ends (L; 66) are connected to a second cathode bar (68), and in that the two cathode bars are alternately connectable to the negative pole of the direct-current generator.

17. Arrangement for accomplishing the method according to one of claims 1 - 5, characterised in that at least two cells (71a, 71b) are disposed one behind the other, when viewed with respect to the direction of travel (72) of the article in a multi-cell bath (71), in that a rectifier (GR 1, 2; GR 3, 4) belongs to each of these cells, in that current connections lead into the respective cell from each of these rectifiers, the current connections on the cell side leading to connections of at least one cathode bar (1) or a supporting frame (64) with frame supporting rods (63), which have means for the mounting of a raw of workpieces (3) situated adjacent one another with a spacing (a) therebetween, the connections with the cathode bar (1) or the supporting frame (64) leading from the first rectifier (GR 1, 2) to the first cell (71a) and the connections with the cathode bar (1) or the supporting frame (64) leading from the second rectifier (GR 3, 4) to the second cell (71b) being mounted on respective oppositely situated ends.

18. Arrangement according to claim 17, characterised in that a plurality of pairs (71a, b; 71c, d) of such cells are disposed behind one another when viewed with respect to the direction of travel (72) of the article in the bath (71).

## Revendications

1. Procédé destiné à éviter les différences d'épaisseur de couche dans le revêtement électrolytique de pièces à traiter disposées à distance les unes des autres dans un bain sur des rails cathodiques ou sur des cadres cathodiques, dans lequel l'alimentation électrique passe dans les rails ou le cadre parallèlement à l'orientation des pièces à traiter, dans lequel le courant est amené par l'une et/ou l'autre extrémité dans le rail cathodique (1, 67, 68), les barres portantes du cadre cathodique (63), les anodes et/ou les rails anodiques (11) maintenant les anodes et le point d'alimentation électrique est changé au moins une fois au moins dans le rail cathodique et/ou les barres portantes du cadre cathodique au cours du traitement électrolytique d'une pièce.

2. Procédé selon la revendication 1, caractérisé en ce que le point d'alimentation électrique assurant le passage du courant dans les anodes ou les rails anodiques (11) est changé en même temps que le point d'alimentation électrique du rail cathodique (1, 67, 68) ou des barres portantes (63) du cadre.

3. Procédé selon l'une quelconque des revendications 1 ou 2, caractérisé en ce que le point d'alimentation électrique du rail cathodique (1, 67, 68) ou des barres portantes (63) du cadre et le point d'alimentation électrique des anodes ou des rails anodiques (11) se trouvent à des extrémités opposées, de sorte que la direction du courant cathodique est opposée à celle du courant anodique.

4. Procédé selon l'une quelconque des revendications 1 à 3, caractérisé en ce que le passage du courant dans une direction n'est coupé que lorsque le courant circulant dans l'autre direction est déjà établi.

5. Procédé selon l'une quelconque des revendications 1 à 4, caractérisé en ce que le changement de point d'alimentation électrique est réalisé soit par le générateur de courant continu (26) soit, à l'intérieur de l'alimentation électrique, entre le générateur de courant continu et les parties de l'installation qui se trouvent dans une cellule du bain, y compris les pièces à traiter (3).

6. Procédé selon l'une quelconque des revendications 1 à 4, caractérisé en ce que les pièces à traiter (3) sont traitées dans une cellule du bain pendant un temps d'exposition donné avec une direction donnée du courant dans les rails cathodiques (1, 67, 68), les barres portantes (63) du cadre ou les anodes ou rails anodiques (11), puis déposées dans une autre cellule du même ou d'un autre bain et traitées dans cette cellule avec une circulation du courant en sens inverse dans les rails cathodiques (1, 67, 68), les barres portantes (63) du cadre et les anodes ou rails anodiques (11) pendant le même temps d'exposition.

7. Dispositif pour la mise en oeuvre du procédé selon l'une quelconque des revendications 1 à 6, caractérisé en ce qu'un rail cathodique (1, 67, 68) ou un cadre portant (64) pourvu de barres portantes (63) présentent des moyens pour l'installation d'une série de pièces à traiter (3) disposées l'une à côté de l'autre et espacées les unes des autres de la distance (a), en ce que le rail cathodique (1, 67, 68) ou le cadre portant (64) peuvent, à l'une de leurs extrémités (L, R) opposées l'une à l'autre, être raccordés électriquement au pôle négatif d'une source de courant, et en ce qu'il est prévu des commutateurs électromécaniques ou des circuits électroniques générateurs de courant continu (26), qui permettent de raccorder alternativement le pôle négatif de la source de courant à une extrémité (L) ou à l'autre extrémité (R).

8. Dispositif selon la revendication 7, caractérisé en ce que les anodes ou les rails anodiques (11) peuvent être connectés à leurs extrémités (L, R) au pôle positif du générateur de courant continu et en ce qu'il est prévu des commutateurs électromécaniques ou des circuits électroniques générateurs de courant continu qui permettent, au même rythme que la commutation sur le rail cathodique (1, 67, 68) ou le cadre portant (64), de connecter soit une extrémité (L) soit l'autre extrémité (R) des anodes ou des rails anodiques (11) au pôle positif du générateur de courant continu.

9. Dispositif selon l'une quelconque des revendications 7 ou 8, caractérisé en ce que deux rails cathodiques (1, 1') sont prévus pour chaque rangée de pièces à traiter (3), en ce que la résistance ohmique par unité de longueur des rails cathodiques (1, 1') diminue dans le sens de circulation du courant (de R à L pour 1, de L à R pour 1'), en ce que chacun de ces rails cathodiques (1, 1') présente pour chacune de ses extrémités (L, R) des connexions séparées au pôle négatif du générateur de courant continu, et en ce que les pièces à traiter (3) sont raccordées aux deux rails cathodiques (1, 1') par des diodes de découplage (8).

10. Dispositif selon la revendication 9, caractérisé en ce que la résistance ohmique par unité de longueur des rails anodiques (11) augmente dans le sens de circulation du courant dans les rails anodiques.

11. Dispositif selon l'une quelconque des revendications 7 à 10, caractérisé en ce que le générateur de courant continu prévu est un dispositif à double redresseur (12, 13) pourvu d'un commutateur électromécanique ou de circuits électroniques générateurs de courant continu alimentant au moins le rail cathodique (1, 67, 68).

12. Dispositif selon la revendication 11, caractérisé en ce qu'il comporte des moyens, par exemple des résistances (25, 25'), permettant de maintenir un courant constant vers le rail cathodique (1, 67, 68) pendant le changement de point d'alimentation électrique.

13. Dispositif selon l'une quelconque des revendications 7 à 10, caractérisé en ce que le générateur de courant continu est formé d'au moins un redresseur à pont monophasé séparé (26 ou 39,40), dont les sorties (33 à 36, 33' à 36') sont reliées par les diodes de redressement (29 à 32 ; 29' à 32') avec le rail cathodique (1, 67, 68) portant les pièces à traiter (3) ou les cadres portants (64), d'une part, et avec les anodes ou les rails anodiques (11), d'autre part.

14. Dispositif selon l'une quelconque des revendications 7 à 10, caractérisé en ce que le générateur de courant continu est formé d'au moins un redresseur à pont triphasé séparé pourvu de six sorties de courant continu, de préférence de deux redresseurs à pont triphasés séparés (53, 54) pourvus de neuf sorties de courant continu, une sortie de courant continu négative étant connectée à une extrémité (R) du rail cathodique (1, 67, 68) tandis qu'une autre sortie de courant continu négative l'est à l'autre extrémité (L) du rail cathodique (1, 67, 68), en ce que des sorties de courant continu positives correspondantes sont connectées aux extrémités (L et R) des anodes ou rails anodiques (11) de l'avant et de l'arrière et en ce que la troisième sortie de courant continu négative du dispositif à redresseurs à pont triphasés séparés est connectée au centre (M) du rail cathodique (1, 67, 68) et les troisièmes sorties positives sont connectées aux centres (M) des anodes ou rails anodiques (11).

15. Dispositif selon l'une quelconque des revendications 7 à 10, caractérisé en ce que le générateur de courant continu est formé d'au moins un redresseur à pont triphasé séparé pourvu de huit sorties de courant continu, de préférence de deux redresseurs à pont triphasés séparés (53, 54) pourvus de douze sorties de courant continu, trois de ces sorties (46, 47, 52) ayant des sorties parallèles (46a, 47a, 52a) réalisées par des diodes de découplage (61, 61', 62, 62') jouant en même temps le rôle de diodes de redressement, et en ce que ces sorties de courant continu parallèles, soit quatre sorties (46, 46a, 47, 47a) sur un redresseur à pont triphasé ou six (46, 46a, 47, 47a, 52, 52a) sur deux redresseurs à pont triphasés sont amenées aux extrémités des anodes ou rails anodiques (11) et aux extrémités du rail cathodique (1, 67, 68) ou d'un cadre portant (64) correspondant, les sorties positives (46, 46a) du premier redresseur à pont (53) aux deux extrémités (L et R) d'une anode ou d'un rail anodique (11), les sorties négatives (47, 47a) du premier redresseur à pont (53), en même temps que les sorties négatives correspondantes du second redresseur à pont (54), aux deux extrémités du rail cathodique (1, 67, 68) ou du cadre portant (64) correspondant et les sorties positives (52, 52a) du second redresseur à pont (54) aux deux extrémités (L et R) de l'autre anode ou rail anodique (11).

16. Dispositif selon l'une quelconque des revendications 7 à 15, caractérisé en ce qu'en vue de leur maintien par des barres (63) de cadres portants (64) les pièces à traiter (3) sont disposées les unes à côté des autres et espacées d'une distance (a) pour former une rangée suivant l'orientation des barres portantes (63) du cadre, en ce que les barres portantes (63) du cadre sont connectées par leurs extrémités (R ; 65) situées d'un côté du dispositif à un premier rail cathodique (67) et par les autres extrémités (L; 66) à un second rail cathodique (68), et en ce que les deux rails cathodiques peuvent être alternativement raccordés au pôle négatif du générateur de courant continu.

17. Dispositif pour la mise en oeuvre du procédé selon l'une quelconque des revendications 1 à 5, caractérisé en ce qu'il est prévu dans un bain (71) à plusieurs cellules au moins deux cellules (71a, 71b) situées l'une derrière l'autre dans le sens de transport (72) des articles, en ce qu'un redresseur (GR 1, 2; GR 3, 4) est associé à chacune de ces cellules, en ce que des connexions électriques vont de chacun de ces redresseurs à la cellule correspondante, les connexions électriques du côté de la cellule menant à des connexions sur au moins un rail cathodique (1) ou un cadre portant (64) pourvu de barres portantes (63), qui présentent des moyens pour la disposition d'une rangée de pièces à traiter (3) situées les unes à côté des autres à une certaine distance (a) les unes des autres, les connexions allant du premier redresseur (GR 1, 2) à la première cellule (71a) étant appliquées sur le rail cathodique (1) ou le cadre portant (64) et les connexions allant du second redresseur (GR 3, 4) à la seconde cellule (71b) sur le rail cathodique (1) ou le cadre portant (64) à des extrémités opposées.

18. Dispositif selon la revendication 17, caractérisé en ce que plusieurs paires (71a, b; 71c, d) de cellules de ce type étant disposées les unes derrière les autres dans le sens de transport (72) des articles dans le bain (71).
